# EUROPEAN PATENT SPECIFICATION

(11) **EP 2 720 521 B1**
(45) Date of publication and mention of the grant of the patent: **22.06.2016**
(21) Application number: 13183830.2
(22) Date of filing: 11.09.2013
(51) Int. Cl.: H05K 5/00

(54) **Electrical connection box**
Elektrischer Anschlusskasten
Boîtier de connexion électrique

(30) Priority: 09.10.2012 JP 2012223849
(43) Date of publication of application: 16.04.2014
(73) Proprietor: Sumitomo Wiring Systems, Ltd., Yokkaichi Mie 510-8503 (JP)
(72) Inventor: Hayashi, Tomohide, Yokkaichi, Mie 510-8503 (JP)
(74) Representative: Horn Kleimann Waitzhofer Patentanwälte PartG mbB

(56) References cited:
- US-A1- 2003 188 882
- US-A1- 2006 046 535
- US-A1- 2006 270 255

## Description

### TECHNICAL FIELD

The present invention relates to an electrical connection box for provision in an automobile or the like, and in particular relates to an electrical connection box in which a connector provided on a circuit board housed inside a case is exposed to the outside through an opening portion in the case.

### BACKGROUND ART

Conventionally, electrical connection boxes have been used in automobiles and the like in order to, for example, efficiently distribute power from a power source such as a battery to various electrical components. For example, JP 2008-172889A (Patent Document 1) discloses a known example of such an electrical connection box, which is configured as an ECU (Electronic Control Unit) in which a circuit board is housed inside a case, and which can be attached to and detached from another electrical connection box such as a junction box. Another example of an electrical connection box is disclosed in US 2006/0046535, Denso Corp., published on March 2, 2006.

With the electrical connection box disclosed in Patent Document 1, the connector provided on the circuit board is exposed to the outside through an opening portion provided in the case. When the case is then attached to another electrical connection box, the connector is thereby connected to another connector provided in the other electrical connection box.

With this kind of electrical connection box, the circuit board inside the case is exposed to outside through a gap between the connector and the opening portion in the case. For this reason, foreign matter such as dust outside the case can enter through the gap or unintentionally be inserted into the gap, thus having the risk of damaging the circuit board inside the case.

In order to prevent the entrance of such foreign matter, there has been demand for the dimensions of the gap between the connector and the opening portion in the case to be made as small as possible. However, the ability to reduce the size of the gap between the opening portion and the connector has been limited by the fact that certain dimensions are always necessary in order to allow the insertion of the connector into the opening portion during the manufacturing of the electrical connection box, and in order to ensure space for housing another connector that will be a female connector in many cases.

JP 2008-172889A is an example of related art.

### SUMMARY OF THE INVENTION

The present invention has been achieved in light of the above-described circumstances, and an object thereof is to provide an electrical connection box with a novel structure, in which a connector is exposed to the outside of a case through an opening portion in the case, and it is possible to prevent the entrance of foreign matter through a gap between the opening portion and the connector.

A first aspect of the present invention is an electrical connection box in which a circuit board is housed inside a case, and in which a connector provided projecting from the circuit board is arranged inside an opening portion formed in the case and is exposed to the outside of the case, the connector being provided with a covering plate portion that spreads out parallel to the circuit board, and a gap between the connector and the opening portion in the case being blocked by the covering plate portion.

According to an electrical connection box having the structure of the present invention, in a projection view from ahead in the projection direction of the connector, the gap between the connector and the opening portion in the case is blocked by the covering plate portion that projects outward from the connector parallel to the circuit board. This makes it possible to prevent the circuit board from being exposed to the outside through the gap between the opening portion and the connector, and prevent the circuit board from being damaged by the entrance of foreign matter through the gap. In particular, merely changing the shape of the connector enables preventing the circuit board from being exposed to the outside, and prevents damage to the circuit board with superior cost efficiency.

Note that the present invention is not limited to being applied to an electrical connection box such as an ECU unit that is attached to another electrical connection box such as a junction box. The present invention is widely applicable to various types of electrical connection boxes in which a connector is exposed to the outside through an opening portion in a case, and is also applicable to electrical connection boxes that are used in a standalone manner rather than being attached to other electrical connection boxes.

A second aspect of the present invention is the first aspect, wherein the covering plate portion may be arranged in a gap between the circuit board and an end edge portion of an inner circumferential wall of the opening portion in the case, the end edge portion being on a circuit board side of the inner circumferential wall.

In this aspect, the covering plate portion is provided inside the gap between the case and the circuit board. This enables the gap between the opening portion and the connector to be completely covered by the covering plate portion in a projection view from the opening side of the opening portion. As a result, it is possible to more effectively prevent the entrance of foreign matter through the gap between the opening portion and the connector.

A third aspect of the present invention is the first aspect or the second aspect, wherein the covering plate portion is provided with a plurality of leg portions that project toward the circuit board at a predetermined interval in a longitudinal direction of the covering plate portion, the covering plate portion may be arranged so as to be separated from the circuit board and supported by the plurality of leg portions, and a solder checking window may be formed by the covering plate portion and a pair of the leg portions that are adjacent.

In this aspect, it is possible to view soldering portions for soldering terminals of the connector to the circuit board through solder checking windows defined by the covering plate portion and the circuit board. This makes it possible to ensure the ability to view the solder even when the covering plate portion that spreads out parallel to the circuit board is formed so as to project outward from the connector.

A fourth aspect of the present invention is any one of the first to third aspects, wherein, by attaching the case to another electrical connection box, the connector may be connected to another connector provided on the other electrical connection box.

According to this aspect, in the electrical connection box such as an ECU unit that is attached to another electrical connection box such as a junction box, it is possible to prevent the entrance of foreign matter through the gap between the connector and the opening portion in the case, and prevent the circuit board inside the case from being damaged.

In the present invention, the covering plate portion that spreads out parallel to the circuit board is provided on the connector arranged inside the opening portion in the case, and the gap between the connector and the opening portion in the case is blocked by the covering plate portion. This makes it possible to prevent foreign matter from coming into contact with the circuit board through the gap between the opening portion and the connector, and prevent the circuit board from being damaged. In particular, the circuit board can be protected in a cost efficient manner by merely changing the shape of the connector.

### BRIEF DESCRIPTION OF THE DRAWINGS

Fig. 1 is a perspective view of an intermediate state in the attachment of one electrical connection box according to an embodiment of the present invention to another electrical connection box.
Fig. 2 is a bottom view of the electrical connection box shown in Fig. 1.
Fig. 3 is a bottom view of a printed circuit board housed in the electrical connection box shown in Fig. 1.
Fig. 4 is a view along arrow A in Fig. 3.
Fig. 5 is an enlarged view of main portions in a cross-section taken along V-V in Fig. 2.

### EMBODIMENTS OF THE INVENTION

An embodiment of the present invention will be described below with reference to the drawings.

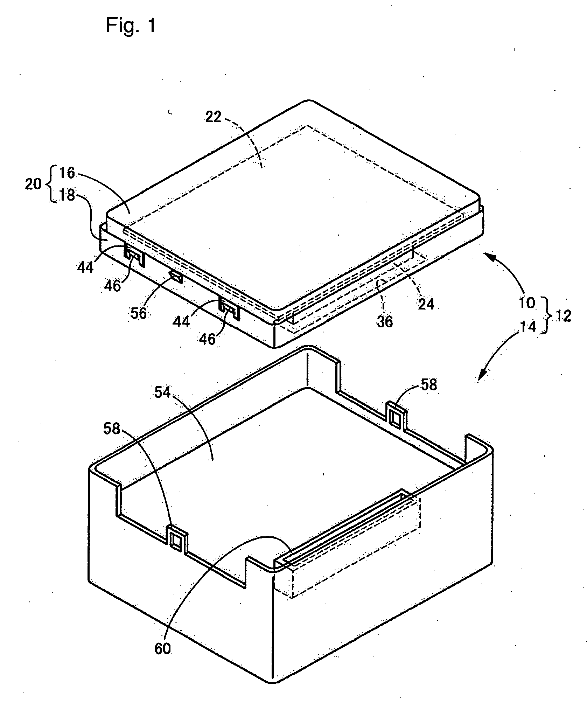

Firstly, Fig. 1 shows a junction box 12 that includes an ECU unit 10 pertaining to an electrical connection box serving as an embodiment of the present invention. The junction box 12 is configured by attaching the ECU unit 10 to a body unit 14 serving as another electrical connection box.

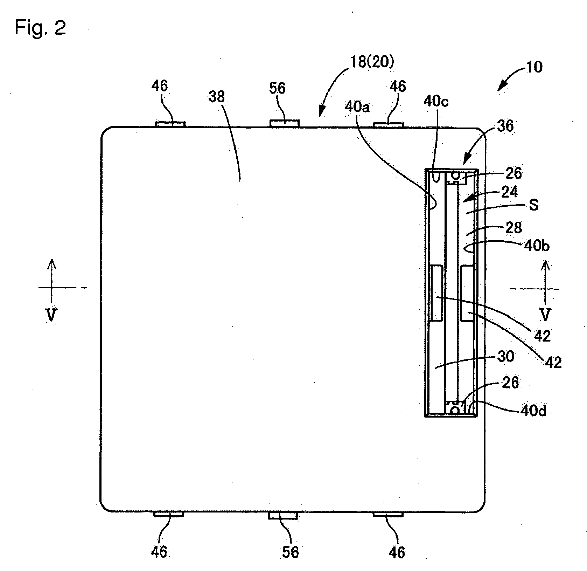

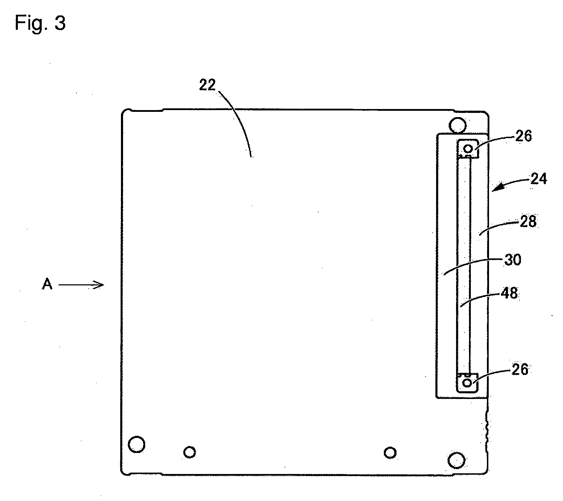

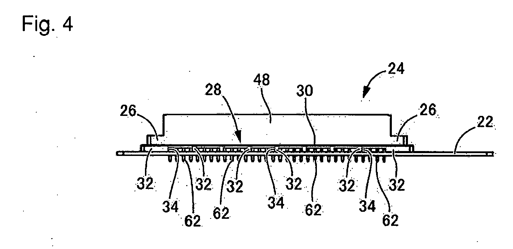

Fig. 2 shows the ECU unit 10. The ECU unit 10 is structured such that a printed circuit board 22, which is shown in Figs. 3 and 4 and serves as a circuit board, is housed in a case 20 that is shaped as a rectangular box and is obtained by assembling an upper case 16 and a lower case 18 that are made of a synthetic resin.

The printed circuit board 22 is provided with a connector 24. The connector 24 is made of a synthetic resin and shaped as an elongated block. Bolt fixing portions 26, which are respectively formed on the two longitudinal (up-down direction in Fig. 3) end portions of the connector 24, are fixed to the printed circuit board 22 with bolts (not shown), and thus the connector 24 is provided so as to project outward from the printed circuit board 22.

A covering plate portion 28 is formed so as to be integrated with the connector 24. The covering plate portion 28 is shaped as an elongated rectangular plate that projects outward over the entire circumference of the connector 24 in a direction orthogonal to the direction in which the connector 24 projects outward from the printed circuit board 22 (up-down direction in Fig. 4). Accordingly, the covering plate portion 28 is formed so as to spread out parallel to the printed circuit board 22. The lengthwise (up-down direction in Fig. 3) dimension and widthwise (left-right direction in Fig. 3) dimension of the covering plate portion 28 are greater than the lengthwise and widthwise dimensions of an opening portion 36 formed in a later-described lower case 18, and thus the covering plate portion 28 is formed such that its dimensions are greater than the opening dimensions of the later-described opening portion 36.

As is clearly shown in Fig. 4, an inner plate portion 30 that extends in the longitudinal direction of the connector 24 is located on the covering plate portion 28 at a position that is inward with respect to the printed circuit board 22, and is positioned so as to be somewhat separated upward from the printed circuit board 22. Multiple leg portions 32 that project toward the printed circuit board 22 are formed so as to be integrated with the inner plate portion 30 with a predetermined interval in the longitudinal direction of the inner plate portion 30. The leg portions 32 are in contact with the printed circuit board 22, and thus the inner plate portion 30 is supported over the printed circuit board 22 by the leg portions 32, so as to be separated from the printed circuit board 22. Due to the gap between the inner plate portion 30 and the printed circuit board 22 being partitioned in the longitudinal direction of the inner plate portion 30 by the leg portions 32, multiple solder viewing windows 34 that open toward the interior of the printed circuit board 22 are defined by the inner plate portion 30 and pairs of adjacent leg portions 32.

On the other hand, as shown in Fig. 2, an opening portion 36 is formed in an end edge portion of the lower case 18 that corresponds to the connector 24. The opening portion 36 is shaped as an elongated rectangle that pierces through a bottom face 38 of the lower case 18. Among inner circumferential walls 40 of the opening portion 36, support fins 42 that project toward the interior of the opening portion 36 are formed in the central portion of a pair of inner circumferential walls 40a and 40b that extend in the longitudinal direction.

The upper case 16 and the lower case 18 are attached to each other so as to sandwich the printed circuit board 22. The upper case 16 and the lower case 18 are attached to each other by engaging frames 44, which are formed at multiple locations on outer circumferential faces of the lower case, being engaged with engaging claws 46 that are formed at corresponding positions on the upper case 16. Accordingly, the case 20 is formed by the upper case 16 and the lower case 18 being attached each other, and ECU unit 10 is formed by the printed circuit board 22 being housed in the case 20.

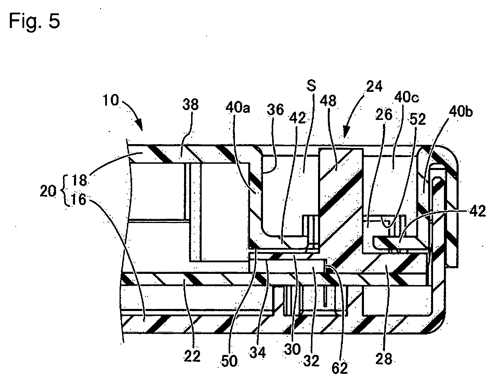

As shown in Fig. 5, when housed in the case 20, the connector 24 is housed inside the opening portion 36 of the case 20, and is exposed to the outside of the case 20. Note that the upper side in Fig. 5 is the body unit 14 side. A tip portion 48 of the connector 24 is inserted between the support fins 42, and is in a loosely inserted state in which it is separated from the inner circumferential faces of the opening portion 36 over the entire circumference. Accordingly, the support fins 42 overlap with the covering plate portion 28 of the connector 24 via a slight gap in the opening direction of the opening portion 36 (from the lower side to the upper side in Fig. 5).

Also, end edge portions 50 of the inner circumferential walls 40 of the opening portion 36, which are on the printed circuit board 22 side, are positioned so as to be separated from the printed circuit board 22 via a gap. The covering plate portion 28 of the connector 24 projects outward from the connector 24, and is arranged between the printed circuit board 22 and the end edge portions 50 of the inner circumferential walls 40 over the entire circumference. Note that the bolt fixing portions 26 of the connector 24 are provided inside the case 20 through notches 52 that are formed in inner circumferential walls 40c and 40d that extend in the widthwise direction of the opening portion 36 (only the inner circumferential wall 40c is shown in Fig. 5). Accordingly, a gap S between the connector 24 and the opening portion 36 is blocked (occluded) by the covering plate portion 28 over the entire circumference in a projection view from ahead in the projection direction of the connector 24 (see Fig. 2).

The ECU unit 10 having this structure is attached to the body unit 14 as shown in Fig. 1. With this ECU unit 10, the bottom face 38 of the lower case 18 is placed over an attachment face 54 of the body unit 14, and locking claws 56 formed on the lower case 18 are engaged with locking frames 58 formed at corresponding positions on the body unit 14. Accordingly, the case 20 of the ECU unit 10 is attached to the body unit 14, thus configuring the junction box 12.

When the ECU unit 10 is attached to the body unit 14, a female connector 60 serving as another connector projecting from the attachment face 54 of the body unit 14 is inserted into the opening portion 36 of the ECU unit 10, and is connected so as to be inserted into the connector 24 of the ECU unit 10 arranged in the opening portion 36. As a result, the printed circuit board 22 of the ECU unit 10 is connected via the connector 24 and the female connector 60 to an electrical circuit (not shown) such as a printed wiring circuit that is provided in the body unit 14.

As shown in Fig. 5, in the ECU unit 10 having the structure of the present embodiment, the gap S between the connector 24 and the opening portion 36 in the case 20 is blocked by the covering plate portion 28 that projects out from the connector 24. This prevents the printed circuit board 22 from being exposed to the outside of the case 20 through the gap S, and prevents foreign matter from coming into contact with the printed circuit board 22 through the gap S. As a result, it is possible to protect the printed circuit board 22 from damage due to contact with foreign matter.

In particular, the covering plate portion 28 is inserted in between the printed circuit board 22 and the inner circumferential walls 40 of the opening portion 36. Accordingly, the gap between the opening portion 36 and the connector 24 is completely blocked, and it is possible to more highly reliably prevent the entrance of foreign matter. Also, it is possible to protect the printed circuit board 22 from contact with foreign matter in a cost efficient manner by merely applying a specific shape such as that of the present embodiment for the connector 24.

Also, the support fins 42 are arranged so as to be on the opening side (upper side in Fig. 5) of the opening portion 36 relative to the covering plate portion 28. Accordingly, when the ECU unit 10 is detached from the body unit 14, it can be smoothly removed from the female connector 60 since the connector 24 is supported due to the support fins 42 coming into contact with the covering plate portion 28.

Furthermore, the solder viewing windows 34 are formed between the printed circuit board 22 and the inner plate portion 30 of the covering plate portion 28, which is positioned toward the interior of the printed circuit board 22. Accordingly, soldering portions for the attachment of connection terminals 62 of the connector 24 to the printed circuit board 22 can be viewed through the solder viewing windows 34, and the covering plate portion 28 can be formed so as to spread out parallel to the printed circuit board 22 while ensuring the ability to view the soldering portions for soldering the connection terminals 62.

Although an embodiment of the present invention has been described in detail above, the present invention is not limited to this specific description. For example, the covering plate portion is not limited to always being formed with dimensions greater than the opening dimensions of the opening portion as in the above embodiment so as to be large enough to completely block the gap between the opening portion and the connector. The dimensions may be smaller than the opening dimensions of the opening portion as long as it is possible to form a narrower gap between the opening portion and the connector. Furthermore, it is not necessarily required to provide the solder viewing windows 34 and the support fins 42 described in the above embodiment.

Also, the present invention is not limited to being applied to an electrical connection box such as the ECU unit that is attached to another electrical connection box such as a junction box as in the above embodiment. The present invention is widely applicable to various types of electrical connection boxes such as fuse boxes and junction boxes that are used in a standalone manner.

## Claims

1. An electrical connection box in which a circuit board (22) is housed inside a case (20) having an upper case (16) and a lower case (18), and in which a connector (24) provided projecting from the circuit board (22) is arranged inside an opening portion (36) formed in the lower case (20) and is exposed to the outside of the case (20),
the opening portion (36) being shaped as an elongated rectangle that pierces through a bottom face (38) of the lower case (18),
the connector (24) being provided with a covering plate portion (28) that spreads out parallel to the circuit board (22), and
a gap between the connector (24) and the opening portion (36) in the lower case (18) being blocked by the covering plate portion (28).

2. The electrical connection box according to claim 1,
wherein the covering plate portion (28) is arranged in a gap between the circuit board (22) and an end edge portion (50) of an inner circumferential wall (40) of the opening portion (36) in the case (20), the end edge portion (50) being on a circuit board side of the inner circumferential wall (40).

3. The electrical connection box according to claim 1 or 2,
wherein the covering plate portion (28) is provided with a plurality of leg portions (32) that project toward the circuit board (22), the plurality of leg portions (32) being formed at a predetermined interval in a longitudinal direction of the covering plate portion (28),
the covering plate portion (28) is arranged so as to be separated from the circuit board (22) and supported by the plurality of leg portions (32), and
a solder checking window (34) is formed by the covering plate portion (28) and a pair of the leg portions (32) that are adjacent.

4. The electrical connection box according to any one of claims 1 to 3,
wherein, by attaching the case (20) to another electrical connection box, the connector (24) can be connected to another connector (60) provided on the other electrical connection box.

## Patentansprüche

1. Elektrischer Anschlusskasten, in welchem eine Platine (22) innerhalb eines Gehäuses (20), welches ein oberes Gehäuse (16) und ein unteres Gehäuse (18) aufweist, eingehaust ist und in welchem ein Verbindungsglied (24) vorgesehen ist, das aus der Platine (22) hervorspringt und innerhalb eines Öffnungsabschnitts (36), der in dem unteren Gehäuse (18) ausgebildet ist und zur Außenseite des Gehäuses (20) weist, angeordnet ist,
wobei der Öffnungsabschnitt (36) als ein längliches Rechteck geformt ist, welches eine Bodenseite (38) des unteren Gehäuses (18) durchdringt,
wobei das Verbindungsglied (24) mit einem Deckplattenabschnitt (28) vorgesehen ist, welcher sich parallel zur der Platine (22) erstreckt, und
wobei ein Spalt zwischen dem Verbindungsglied (24) und dem Öffnungsabschnitt (36) in dem unteren Gehäuse (18) mittels des Deckplattenabschnitts (28) versperrt ist.

2. Elektrischer Anschlusskasten nach Anspruch 1,
wobei der Deckplattenabschnitt (28) in einem Spalt zwischen der Platine (22) und einem Endkantenabschnitt (50) einer inneren umlaufenden Wand (40) des Öffnungsabschnitts (36) in dem Gehäuse (20) angeordnet ist, wobei der Endkantenabschnitt (50) an einer Platinenseite der inneren umlaufenden Wand (40) ist.

3. Elektrischer Anschlusskasten nach Anspruch 1 oder 2,
wobei der Deckplattenabschnitt (28) mit einer Vielzahl von Beinabschnitten (32) vorgesehen ist, die durch die Platine (22) ragen, wobei die Vielzahl von Beinabschnitten (32) in einem vorbestimmten Intervall in Längsrichtung des Deckplattenabschnitts (28) ausgebildet ist,
wobei der Deckplattenabschnitt (28) derart vorgesehen ist, dass dieser von der Platine (22) separierbar ist und mittels der Vielzahl von Beinabschnitten (32) gestützt ist, und
wobei ein Lötmittel-Kontrollfenster (34) durch den Deckplattenabschnitt (28) ausgebildet ist und ein Paar der Beinabschnitte (32) benachbart ist.

4. Elektrischer Anschlusskasten nach einem der Ansprüche 1 bis 3,
wobei mittels Verbinden des Gehäuses (20) an einen anderen elektrischen Anschlusskasten das Verbindungsglied (24) mit einem anderen Verbindungsglied (60), welches an dem anderen Anschlusskasten vorgesehen ist, verbindbar ist.

## Revendications

1. Boîte de connexion électrique dans laquelle une carte de circuits imprimés (22) est logée à l'intérieur d'un boîtier (20) comportant un boîtier supérieur (16) et un boîtier inférieur (18), et dans laquelle un connecteur (24) faisant saillie depuis la carte de circuits imprimés (22) est disposé à l'intérieur d'une partie formant ouverture (36) ménagée dans le boîtier inférieur (20) et est exposé à l'extérieur du boîtier (20),
la partie formant ouverture (36) étant réalisée selon une forme de rectangle allongé qui perfore une face inférieure (38) du boîtier inférieur (18),
le connecteur (24) étant pourvu d'une partie formant plaque de recouvrement (28) qui s'étend parallèlement à la carte de circuits imprimés (22), et
un espace entre le connecteur (24) et la partie formant ouverture (36) dans le boîtier inférieur (18) étant obstrué par la partie formant plaque de recouvrement (28).

2. Boîte de connexion électrique selon la revendication 1,
dans laquelle la partie formant plaque de recouvrement (28) est disposée dans un espace entre la carte de circuits imprimés (22) et une partie formant bord d'extrémité (50) d'une paroi circonférentielle intérieure (40) de la partie formant ouverture (36) ménagée dans le boîtier (20), la partie formant bord d'extrémité (50) se trouvant d'un côté carte de circuits imprimés de la paroi circonférentielle intérieure (40).

3. Boîte de connexion électrique selon la revendication 1 ou 2,
dans laquelle la partie formant plaque de recouvrement (28) est pourvue d'une pluralité de parties formant pattes (32) qui font saillie vers la carte de circuits imprimés (22), la pluralité de parties formant pattes (32) étant formée à un intervalle prédéterminé, dans un sens longitudinal de la partie formant plaque de recouvrement (28),
la partie formant plaque de recouvrement (28) est disposée de manière à être séparée de la carte de circuits imprimés (22) et supportée par la pluralité de parties formant pattes (32), et
une fenêtre de contrôle de soudures (34) est formée par la partie formant plaque de recouvrement (28) et une paire de parties formant pattes (32) qui sont voisines.

4. Boîte de connexion électrique selon l'une quelconque des revendications 1 à 3,
dans laquelle, en reliant le boîtier (20) à une autre boîte de connexion électrique, il est possible de connecter le connecteur (24) à un autre connecteur (60) se trouvant sur l'autre boîte de connexion électrique.
